# EUROPÄISCHE PATENTANMELDUNG

(11) **EP 3 035 780 A1**
(43) Veröffentlichungstag der Anmeldung: **22.06.2016**
(21) Anmeldenummer: 14198897.2
(22) Anmeldetag: 18.12.2014
(51) Int. Cl.: H05K 7/14, H05K 7/20

(54) **Kühlkörper**

(71) Anmelder: Siemens Aktiengesellschaft, 80333 München (DE)
(72) Erfinder: Bergmann, Martin, 92253 Schnaittenbach (DE); Busch, Klaus, 92224 Amberg (DE); Bäuml, Mathias, 92421 Schwandorf (DE); Wiesner, Christoph, 92272 Aschach (DE)

(57) **Zusammenfassung**

Die Erfindung betrifft einen Kühlkörper (1), welcher im Wesentlichen quaderförmig ausgestaltet ist, wobei in eine erste äußere Seitenfläche (21) einer ersten Wand (11) des Quaders eine eingearbeitete erste Kühlkontaktfläche (2) und in eine zweite äußere Seitenfläche (22) einer zweiten Wand (12) des Quaders eine eingearbeitete zweite Kühlkontaktfläche (3) vorhanden ist, wobei
- die zweite Wand (12) senkrecht auf der ersten Wand (11) angeordnet ist und dadurch eine erste Kante (K1) gebildet ist,
- eine dritte Wand (13) senkrecht auf der zweiten Wand (12) angeordnet ist und dadurch eine zweite Kante (K2) gebildet ist,
- eine vierte Wand (14) senkrecht auf der dritten Wand (13) angeordnet ist und dadurch eine dritte Kante (K3) gebildet ist,
- die erste Wand (11) senkrecht auf der vierten Wand (14) angeordnet ist und dadurch eine vierte Kante (K4) gebildet ist,

wobei die Wände (11,12,13,14) derart angeordnet sind das ein Innenraum (30) mit einer Medium-Eintrittsöffnung (15) und einer Medium-Austrittsöffnung (16) vorhanden ist, wodurch ein Strömungskanal (37) für ein Kühlmedium gebildet ist.

## Beschreibung

Die Erfindung betrifft einen Kühlkörper, welcher im Wesentlichen quaderförmig ausgestaltet ist, wobei in eine erste äußere Seitenfläche einer ersten Wand des Quaders eine eingearbeitete erste Kühlkontaktfläche und in eine zweite äußere Seitenfläche einer zweiten Wand des Quaders eine eingearbeitete zweite Kühlkontaktfläche vorhanden ist.

Aufgrund einer Miniratisierung von Elektronikkomponenten, wird zunehmend eine höhere Packungsdichte/Funktionsdichte an elektronischen Komponenten/Bauteilen auf einer Flachbaugruppe, wie beispielsweise einer bestückten Leiterplatte, realisiert. Dies führt zu einer Erhöhung der Verlustleistung, insbesondere bei Mikroprozessoren, insbesondere bei Mikroprozessoren im Mehrkernbetrieb, weil Leistungsfähigkeit von Mikroprozessoren zunehmend steigt, steigt auch die Verlustwärme.

Insbesondere bei Elektronikkomponenten, welche in der industriellen Automatisierungstechnik eingesetzt werden, existieren nochmals erhöhte Anforderungen an die Kühlung eines elektronischen Bauteils, beispielsweise auf der Flachbaugruppe einer speicherprogrammierbaren Steuerung. Da die speicherprogrammierbare Steuerung üblicherweise in einem industriellen Umfeld eingesetzt werden, in welchen bereits eine erhöhte Umgebungstemperatur herrscht, ist es noch schwieriger geworden die Verlustwärme abzuführen.

Die Rechenleistung eines Automatisierungsgerätes führt zu einer Verlustleistung. Je höher die Rechenleistung, desto höher die Verlustleistung (Wärme). Die verwendeten Prozessoren werden immer leistungsfähiger, die Verlustleistung steigt somit.

In der europäischen Veröffentlichung EP 2 736 312 A1 ist ein Automatisierungsgerät mit einem Kühlkörper offenbart. Um die Leistungsdichte des offenbarten Automatisierungsgerätes zu erhöhen, wird vorgeschlagen, einen quaderförmig ausgestalteten Kühlkörper mit einer in einer Seitenfläche des Quaders eingearbeiteten ersten Kühlkontaktfläche an einer ersten Leiterplatte zu positionieren und mit einer in einer zweiten Seitenfläche des Kühlkörpers eingearbeiteten zweiten Kühlkontaktfläche an einer zweiten Leiterplatte zu positionieren um die Verlustleistung abzuführen.

Der bekannte Kühlkörper hat den Nachteil, dass er insbesondere dann wenn Mikroprozessoren im Mehrkernbetrieb eingesetzt werden, die entstehende Verlustleistung nicht mehr genügend abführen kann und das nach dem Stand der Technik bekannte Automatisierungsgerät mit dem bekannten Kühlkörper überhitzen würde.

Es ist Aufgabe der vorliegenden Erfindung den bekannten Kühlkörper derart weiterzubilden, dass das Kühlverhalten verbessert wird bzw. die entstehende Verlustwärme besser abgeführt werden kann.

Bei dem bekannten Kühlkörper, welcher im Wesentlichen quaderförmig ausgestaltet ist, wobei in eine erste äußere Seitenfläche einer ersten Wand des Quaders eine eingearbeitet erste Kühlkontaktfläche und in eine zweite äußere Seitenfläche einer zweiten Wand des Quaders eine eingearbeitete zweite Kühlkontaktfläche vorhanden ist, wird die Aufgabe dadurch gelöst, dass die zweite Wand senkrecht auf der ersten Wand angeordnet ist und dadurch eine erste Kante gebildet ist, eine dritte Wand senkrecht auf der zweiten Wand angeordnet ist und dadurch eine zweite Kante gebildet ist, eine vierte Wand senkrecht auf der dritten Wand angeordnet ist und dadurch eine dritte Kante gebildet ist, die erste Wand senkrecht auf der vierten Wand angeordnet ist und dadurch eine vierte Kante gebildet ist, wobei die Wände derart angeordnet sind, dass ein Innenraum mit einer Medium-Eintrittsöffnung und einer Medium-Austrittsöffnung vorhanden ist, wodurch ein Strömungskanal für ein Kühlmedium gebildet ist. Dadurch, dass die Wände einen abgegrenzten Innenraum bilden, kann beispielsweise Umgebungsluft als Kühlmedium besser und rascher durch den Kühlkörper strömen und somit die von dem Kühlkörper aufgenommene Verlustwärme besser abführen.

Eine weitere Verbesserung wird erreicht, wenn im Innenraum Kühl-Lamellen angeordnet sind.

In einer weiteren Ausgestaltung wird das thermische Verhalten noch weiter optimiert, wobei in der weiterführenden Ausgestaltung der Innenraum eine Wärmeleitungswand aufweist, welche senkrecht auf der ersten inneren Seitenfläche der ersten Wand angeordnet ist und die erste Wand mit der dritten Wand verbindet, wobei die Wärmeleitungswand im Wesentlichen mittig zur ersten Kühlkontaktfläche angeordnet ist. Die in den Innenraum eingebrachte Wärmeleitungswand beeinflusst das Strömungsverhalten durch den Innenraum nur unwesentlich, aber sorgt dafür, dass ein in die erste Wand einströmender Wärmestrom besser verteilt werden kann und insbesondere zur gegenüberliegenden dritten Wand geleitet werden kann, wodurch sich der Wärmestrom auf der gesamten Quaderoberfläche besser verteilen kann.

Weiterhin ist es vorteilhaft, wenn durch die vier miteinander verbundenen Wände ein annähernd rechteckiger Umfangsverlauf einen Wärmeleitungsrahmen bildet. Damit könnte die erste Wand mit der ersten Kühlkontaktfläche als eine Hauptkühlfläche, beispielsweise für einen Mehrkernprozessor, angesehen werden und die zweite Wand mit der zweiten Kühlkontaktfläche als eine Nebenkühlfläche für sonstige elektronische Bauteile angesehen werden. Dadurch, dass senkrecht auf der Hauptkühlfläche die Wärmeleitungswand im Wesentlichen mittig zur ersten Kühlkontaktfläche angeordnet ist, wird von der Hauptkühlfläche, insbesondere von dem Mikroprozessor im Mehrkernbetrieb, der größte Wärmestrom zur gegenüberliegenden dritten Wand geführt. Die Wandstärken sind im Vergleich zu den Lamellen-Stärken wesentlich dicker ausgeführt.

Damit der Kühlkörper optimal arbeitet, sollte eine Kühlkörpertemperatur möglichst hoch und über das Kühlkörpervolumen möglichst gleichmäßig verteilt sein. Um das Ziel der gleichmäßig hohen Kühltemperatur zu erreichen, wurde ein massiver äußerer Wärmeleitungsrahmen eingeführt. Dieser hat die Funktion, unabhängig von der eventuell ungleichmäßigen geometrischen Lage der zu kühlenden Bauelemente, innerhalb des Kühlkörpervolumens eine hohe gleichmäßige Temperaturverteilung zu erzeugen. Zwischen zwei gegenüberliegenden Rahmenseiten werden dann die Kühllamellen angeordnet. Aus Kostengründen hinsichtlich der Fertigung wird der damit entstandene "Rahmenkühlkörper" vorteilhaft als ein Teil im Strangpressverfahren hergestellt. Damit ist der erfindungsgemäße Kühlkörper ausgebildet als ein einstückiges Stranggussprofil.

Dem beschriebenen Kühlkörper könnte man prinzipiell hinsichtlich seiner Rahmenkühlkörpergeometrie auch aus mehreren Teilen herstellen, und diese mehreren Teile über ein weiteres Verfahren (z.B. Löten oder Schweißen) verbinden. Dies ist prinzipiell möglich, würde aber die Wirtschaftlichkeit des Herstellungsverfahrens massiv verschlechtern.

Die Zeichnung zeigt ein Ausführungsbeispiel, wobei
- FIG 1: einen Kühlkörper in einer dreidimensionalen Ansicht zeigt,
- FIG 2: den in FIG 1 gezeigten Kühlkörper in einer Schnittdarstellung,
- FIG 3: den gezeigten Kühlkörper in einer weiteren Schnittdarstellung, um einen Umfangsverlauf eines Wärmeleitungsrahmens zu verdeutlichen und die
- FIG 4: den Kühlkörper in einer Draufsicht auf die Kühllamellen.

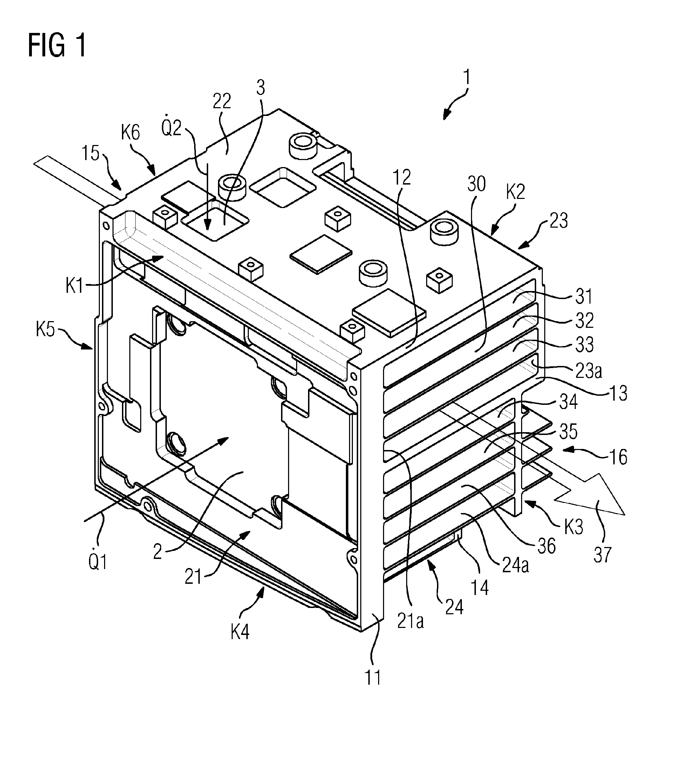

Gemäß der FIG 1 ist ein Kühlkörper 1 dargestellt, welcher gegenüber dem aus dem Stand der Technik bekannten Kühlkörper in seinem Wärmeableitungsverhalten verbessert wurde. Der Kühlkörper 1 ist im Wesentlichen quaderförmig ausgestaltet und weist damit eine erste Wand 11, eine zweite Wand 12, eine dritte Wand 13 und eine vierte Wand 14 auf. In eine erste äußere Seitenfläche 21 der ersten Wand 11 des Quaders ist eine erste Kühlkontaktfläche 2 und in eine zweite äußere Seitenfläche der zweiten Wand 2 des Quaders ist eine zweite Kühlkontaktfläche 3 eingearbeitet. Die Wände 11,12,13,14 sind derart angeordnet, dass ein Innenraum 30 mit einer Medium-Eintrittsöffnung 15 und einer Medium-Austrittsöffnung 16 vorhanden ist, wodurch ein Strömungskanal 37 für ein Kühlmedium gebildet ist.

Demnach steht die zweite Wand 12 senkrecht auf der ersten Wand 11, wodurch eine erste Kante K1 gebildet ist, die dritte Wand 13 steht senkrecht auf der zweiten Wand 12, wodurch eine zweite Kante K2 gebildet ist, die vierte Wand 14 steht senkrecht auf der dritten Wand 13, wodurch eine dritte Kante K3 gebildet ist und die erste Wand 11 steht demnach senkrecht auf der vierten Wand 14 wodurch eine vierte Kante K4 gebildet ist.

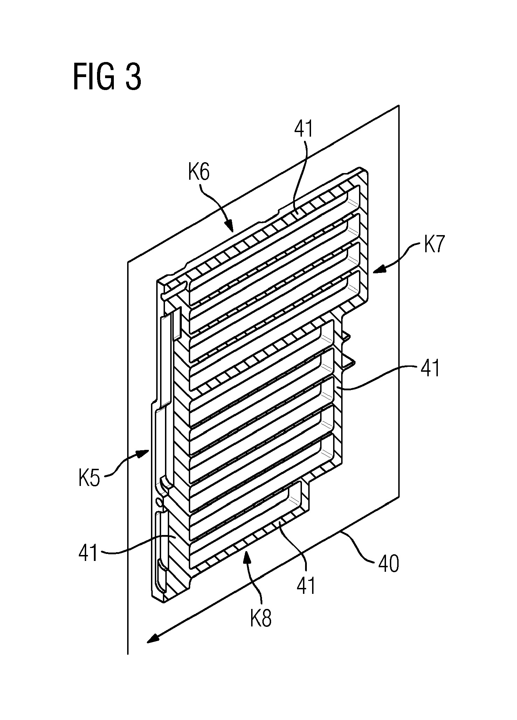

Durch diese Anordnung der Wände 11,12,13,14 wird ein annähernd rechteckiger Umfangsverlauf 40 (FIG 3) der vier miteinander verbunden Wände 11,12,13,14 erzielt, welches einen umlaufenden Wärmeleitungsrahmen 41 bildet. Weiterhin sind im Innenraum 30 eine erste Kühl-Lamelle 31, eine zweite Kühl-Lamelle 32, eine dritte Kühl-Lamelle 33, eine vierte Kühl-Lamelle 34, eine fünfte Kühl-Lamelle 35 und eine sechste Kühl-Lamelle 36 angeordnet. Zwischen der dritten Kühl-Lamelle 33 und der vierten Kühl-Lamelle 34 ist eine Wärmeleitungswand 17 angeordnet, welche senkrecht auf der ersten inneren Seitenfläche 21a der ersten Wand 11 angeordnet ist und die erste Wand 11 mit der dritten Wand 13 verbindet, wobei die Wärmeleitungswand 17 im Wesentlichen mittig zur ersten Kühlkontaktfläche 2 angeordnet ist. Ein in der ersten Kühl-Kontaktfläche 2 angeordnetes elektronisches erstes Bauteil, insbesondere ein Mehrkernmikroprozessor, würde einen ersten Wärmestrom *Q̇*1 in die erste Wand 11 abgeben. Ein in der zweiten Kühlkontaktfläche 3 angeordnetes zweites elektronisches Bauteil würde einen zweiten Wärmestrom *Q̇*2 in die zweite Wand 12 abgeben. Damit insbesondere der erste Wärmestrom *Q̇*1 schnell abgeführt werden kann und sich in dem gesamten Kühlkörper 1 gut verteilt, ist die Innenwand 17 im Wesentlichen mittig zur ersten Kühlkontaktfläche 2 angeordnet.

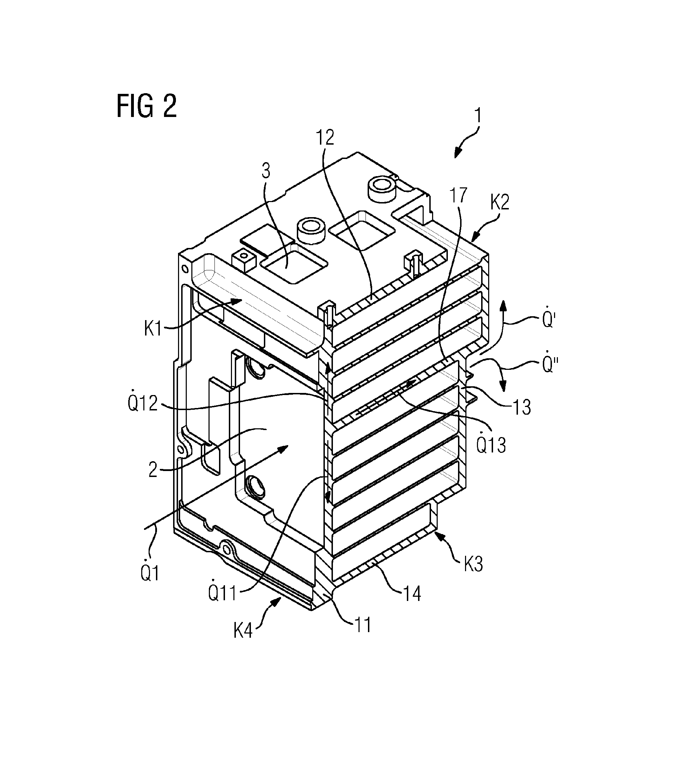

Zur Verdeutlichung des Abführens des ersten Wärmestroms *Q̇*1 ist mit der FIG 2 der Kühlkörper 1 in einer geschnittenen Darstellung abgebildet. Der erste Wärmestrom *Q̇*1 teilt sich in der ersten Wand 11 in einen ersten Teilwärmestrom *Q̇*11, einen zweiten Teilwärmestrom *Q̇*12 und einen dritten Teilwärmestrom *Q̇*13 auf. Der erste Teilwärmestrom *Q̇*11 fließt durch die erste Wand 11 in Richtung der vierten Kante K4, der zweite Teilwärmestrom *Q̇*12 fließt durch die erste Wand 11 in Richtung der ersten Kante K1 und der dritte Teilwärmestrom *Q̇* 13 fließt durch die Wärmeleitungswand 17 in Richtung der dritten Wand 13, wobei er sich dann wieder in der dritten Wand 13 in einen weiteren Teilwärmestrom *Q̇*' in Richtung der zweiten Kante K2 und in einen weiteren Teilwärmestrom *Q̇*" in Richtung der dritten Kante K3 aufteilt. Mit dieser Anordnung der Wände 11,12,13,14 und insbesondere der Ausgestaltung der Wände 11,12,13,14 als ein Wärmeleitungsrahmen 41 (siehe FIG 3) wird im Sinne einer verbesserten Kühlung eine gleichmäßige Kühlkörpertemperatur erreicht.

Eine Verdeutlichung der Ausgestaltung der Wände 11,12,13,14 mit einen annähernd rechteckigen Umfangsverlauf 40, welche so einen massiven Wärmeleitungsrahmen 41 bilden, ist mit der FIG 3 gezeigt. In dieser Schnittdarstellung zeigen im Wesentlichen eine fünfte Kante K5, eine sechste Kante K6, eine siebte Kante K7 und eine achte Kante K8 den Wärmeleitungsrahmen 41.

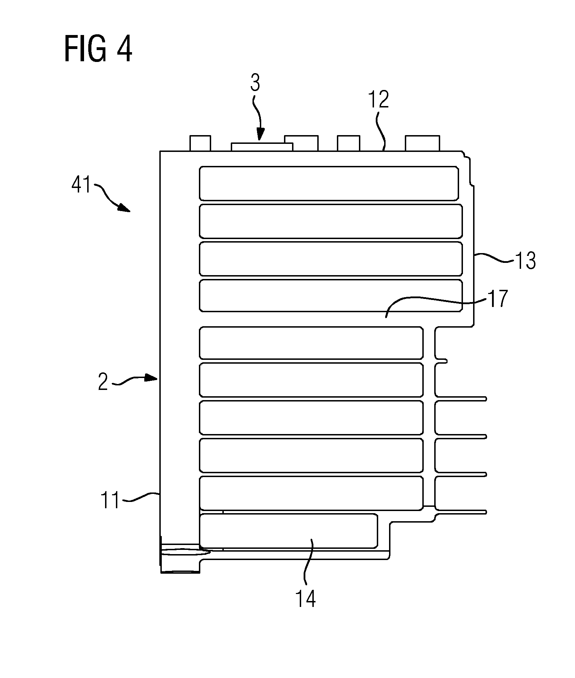

Gemäß FIG 4 ist der Wärmeleitungsrahmen 41 nochmals in einer anderen Darstellung, nämlich in der Draufsicht auf den Kühlkörper 1 abgebildet. Der Wärmeleitungsrahmen 41 wird im Wesentlichen durch die erste Wand 11, die zweite Wand 11, die dritte Wand 13 und die vierte Wand 14 ausgebildet. Zur weiteren Optimierung der Abführung der Wärmeströme *Q̇* ist zwischen der ersten Wand 11 und der dritten Wand 13 eine massive Wärmeleitungswand 17 angeordnet.

Um eine Herstellung eines derartigen Kühlkörpers 1 kostengünstig zu halten, ist der Kühlkörper 1 ausgebildet als ein einstückiges Stranggussprofil. Im Stranggussverfahren hergestellte Kühlkörperprofile, beispielsweise aus Aluminium, welche nach Bedarf zugeschnitten werden können, sind eine preiswert herstellbare Massenware.

## Patentansprüche

1. Kühlkörper (1), welcher im Wesentlichen quaderförmig ausgestaltet ist, wobei in eine erste äußere Seitenfläche (21) einer ersten Wand (11) des Quaders eine eingearbeitete erste Kühlkontaktfläche (2) und in eine zweite äußere Seitenfläche (22) einer zweiten Wand (12) des Quaders eine eingearbeitete zweite Kühlkontaktfläche (3) vorhanden ist,
**dadurch gekennzeichnet, dass**
- die zweite Wand (12) senkrecht auf der ersten Wand (11) angeordnet ist und dadurch eine erste Kante (K1) gebildet ist,
- eine dritte Wand (13) senkrecht auf der zweiten Wand (12) angeordnet ist und dadurch eine zweite Kante (K2) gebildet ist,
- eine vierte Wand (14) senkrecht auf der dritten Wand (13) angeordnet ist und dadurch eine dritte Kante (K3) gebildet ist,
- die erste Wand (11) senkrecht auf der vierten Wand (14) angeordnet ist und dadurch eine vierte Kante (K4) gebildet ist,
wobei die Wände (11,12,13,14) derart angeordnet sind das ein Innenraum (30) mit einer Medium-Eintrittsöffnung (15) und einer Medium-Austrittsöffnung (16) vorhanden ist, wodurch ein Strömungskanal (37) für ein Kühlmedium gebildet ist.

2. Kühlkörper (1) nach Anspruch 1, wobei im Innenraum (30) Kühl-Lamellen (31,...,36) angeordnet sind.

3. Kühlkörper (1) nach Anspruch 1 oder 2, wobei der Innenraum (30) eine Wärmeleitungswand (17) aufweist, welche senkrecht auf der ersten inneren Seitenfläche (21a) der ersten Wand (11) angeordnet ist und die erste Wand (11) mit der dritten Wand (13) verbindet, wobei die Wärmeleitungswand (17) im Wesentlichen mittig zur ersten Kühlkontaktfläche (2) angeordnet ist.

4. Kühlkörper (1) nach einem der Ansprüche 1 bis 3, wobei ein annähernd rechteckiger Umfangsverlauf (40) der vier miteinander verbundenen Wände (11,..,14) einen Wärmeleitungsrahmen (41) bildet.

5. Kühlkörper (1) nach einem der Ansprüche 1 bis 4, ausgebildet als ein einstückiges Stranggussprofil.
